# EUROPEAN PATENT APPLICATION

(11) **EP 2 752 638 A2**
(43) Date of publication of application: **09.07.2014**
(21) Application number: 12836154.0
(22) Date of filing: 26.09.2012
(51) Int. Cl.: G01B 11/30, H05K 13/08

(54) **CONTACTLESS COMPONENT-INSPECTING APPARATUS AND COMPONENT-INSPECTING METHOD**

(30) Priority: 26.09.2011 KR 20110096838
(71) Applicant: Mirtec Co., Ltd., Gunpo, Gyeonggi-do 435-776 (KR)
(72) Inventor: PARK, Chan Wha, Gunpo, Gyeonggi-do 435-776 (KR); JANG, Kwon Kyu, Gunpo, Gyeonggi-do 435-769 (KR); KANG, Keun Hyung, Seoul 152-070 (KR); WANG, Ming Jie, Gunpo, Gyeonggi-do 435-030 (KR); PARK, Hyun Jeong, Gunpo, Gyeonggi-do 435-030 (KR)
(74) Representative: Gille Hrabal
(86) International application number: PCT/KR2012/007728
(87) International publication number: WO 2013/048093

(57) **Abstract**

According to one aspect of the present invention, a contactless component-inspecting apparatus captures, using a camera, images of an object to be inspected that is assembled or mounted during a component assembly process and compares the captured image and a previously inputted image to determine whether the object passes or fails the inspection. The contactless component-inspecting apparatus comprises: a stage unit on which the object to be inspected is mounted, and which fixes or transfers the object to be inspected in/to an inspection location; a lighting unit including a color lighting portion for irradiating the object to be inspected with at least four types of visual light having different wavelength ranges, wherein a first white lighting portion is arranged on the color lighting portion so as to irradiate the object to be inspected with white light, and a second white lighting portion arranged beneath the color lighting portion so as to irradiate the object to be inspected with white light; a camera arranged above the lighting unit so as to capture images of the object to be inspected; an image-processing unit which reads the image captured by the camera so as to determine whether the object to be inspected passes or fails the inspection; and a control unit including a motion controller for controlling the stage unit and the camera unit.

## Description

### Technical Field

The invention relates to a contactless component-inspecting apparatus and component-inspecting method, and more particularly, to a contactless component-inspecting apparatus and component-inspecting method capable of securing correct image information on a soldering part and a main body of an inspection object.

### Background Art

Generally, the surface mounting technologies of assembling the surface mounting part in the printed circuit board and so on include a technology of miniaturizing and integrating the surface mounting part and a technology of developing the precision assembly equipment for precisely assembling this surface mounting part and managing various assembly equipments.

Here, the surface mounting line includes any equipment such as a surface mounting device and a component-inspecting apparatus. The surface mounting device is any equipment for mounting the surface mounting part on the printed circuit board. That is, it serves to receive various surface mounting parts, which are supplied in the form of a tape, a stick, or a tray, from a part feeder and put them on the mounting location of the printed circuit board.

Also, the component-inspecting apparatus serves to inspect the mounting status of the surface mounting part before or after the soldering process of the surface mounting part and then, transfer the printed circuit board to the next process according to the inspection result thereof.

At this time, in the existing component-inspecting method, when the printed circuit board, in which the solder process is completed, is horizontally moved through a conveyor, it controls the initial position by means of the position adjusting apparatus. After the adjustment of the initial position thereof is completed, if a lamp irradiates lights on the printed circuit board, a camera takes a photograph of the soldering part of each surface mounting part.

Thereafter, the component-inspecting apparatus serves to output the inspection state of the soldering part to the monitor to be calculated, so that it can check whether the mounting state is good or bad, or whether the surface mounting part is existing therein or not.

The conventional component-inspecting apparatus of inspecting the component condition of the circuit board is disclosed in Korean patent publication No. 1999-0086297 A.

### Disclosure

### Technical Problem

Accordingly, the present invention has been made to solve the above-mentioned problems occurring in the prior art, and a first object of the present invention is to provide a contactless component-inspecting apparatus and component-inspecting method in that the quality of a soldering part of an inspection object can be accurately determined and an unique color and a character portion of the inspection object can be accurately recognized.

### Technical solution

In order to accomplish this object, there is provided a contactless component-inspecting apparatus for comparing a photographed image of an inspection object with a previously inputted image after the inspection object assembled or mounted during a component assembly process is photographed through a camera and determining whether the inspection object passes or fails an image inspection, including: a stage unit for mounting the inspection object thereon and fixing or transferring the inspection object to an inspection location thereof; a lighting unit having a color lighting portion for irradiating at least four types of visual lights having different wavelength ranges on the inspection object, a first white lighting portion for irradiating a white light on the inspection object located on an upper portion of the color lighting portion, and a second white lighting portion for irradiating a white light on the inspection object located on a lower portion of the color lighting portion; a camera for photographing the inspection object located above the lighting unit; an image-processing unit for reading the image photographed by the camera and determining whether the inspection object passes or fails the image inspection; and a control unit having a motion controller for controlling the stage unit and the camera.

Preferably, the optical axis of the first white lighting portion is parallel to that of the camera.

Preferably, the white light irradiated by the second white lighting unit is irradiated at an angle of less than 45° about a plane of the inspection object.

Preferably, the color lighting unit comprises a red lamp, a yellow lamp, a green lamp, a blue lamp, and a violet lamp.

Preferably, the color lighting unit irradiates the visible lights at different angles and different heights on the inspection object.

In order to accomplish this object, there is provided a contactless component-inspecting method for comparing a photographed image of an inspection object with a previously inputted image after the inspection object assembled or mounted during a component assembly process is photographed through a camera and determining whether the inspection object passes or fails an image inspection, comprising steps of: irradiating at least four types of visual lights having different wavelength ranges, a first white light located on an upper portion of the visual lights, and a second white light located on a lower portion of the visual lights on the inspection object; photographing the inspection object through the camera; extracting a partial image of the inspection object from the photographed image of the inspection object; calculating a color vector value of the inspection object from the extracted partial image of the inspection object; and comparing the calculated color vector value to the established color vector value of a normal state and checking whether the inspection object is normal or abnormal.

Preferably, the inspection object is an electric component mounted on the printed circuit board.

Preferably, the first white light is irradiated on the inspection object in parallel with an optical axis of the camera.

Preferably, the process of extracting the partial image of the inspection object comprises at least any one among a process of extracting the main body image of the inspection object and a process of extracting the image of the soldering part of the inspection object.

Preferably, the plural visible light comprises a red wavelength light, a yellow wavelength light, a green wavelength light, a blue wavelength light, and a violet wavelength light.

### Advantageous Effects

According to the present invention, the quality of the soldering part of the inspection object can be accurately determined and the unique color and the character portion of the inspection object can be accurately recognized.

Also, by omitting the half-reflection mirror equipped in the existing component-inspecting apparatus, the manufacturing cost can be reduced and the amount of light can be increased.

### Brief Description of the Drawings

The above and other objects, features and advantages of the present invention will be more apparent from the following detailed description taken in conjunction with the accompanying drawings, in which:
FIG. 1 illustrates a side sectional view of a contactless component-inspecting apparatus according to one aspect of the present invention;
FIG. 2 illustrates a side sectional view of a lighting unit and a camera of the existing component-inspecting apparatus;
FIG. 3 is images obtained by photographing a character portion, which is marked on a body portion of an electric component mounted on the printed circuit board, by means of the image-inspecting apparatus;
FIG. 4 and FIG. 5 are side views illustrating the shape of the soldering part for connecting the electric component as an inspection object with the printed circuit board and images obtained by photographing the inspection object through a camera;
FIG. 6 illustrates a side sectional view of an entire contactless mounting inspection apparatus according to one embodiment of the present invention; and
FIG. 7 is a flowchart illustrating a contactless component-inspecting method according to another aspect of the present invention.

### Best Mode

### Mode for Invention

Hereinafter, an exemplary embodiment of the present invention will be described in detail with reference to the accompanying drawings.

However, the embodiment of the present invention can turn into various other forms. Also, the scope of the present invention is not restricted to the embodiments explained below. Moreover, the embodiment of the present invention is provided in order to more completely explain the invention to a person having ordinary skill in the art. Therefore, the shape and the size and so on of the elements in the drawings can be exaggerated for the clear description and the elements expressed in the same reference number are the same elements.

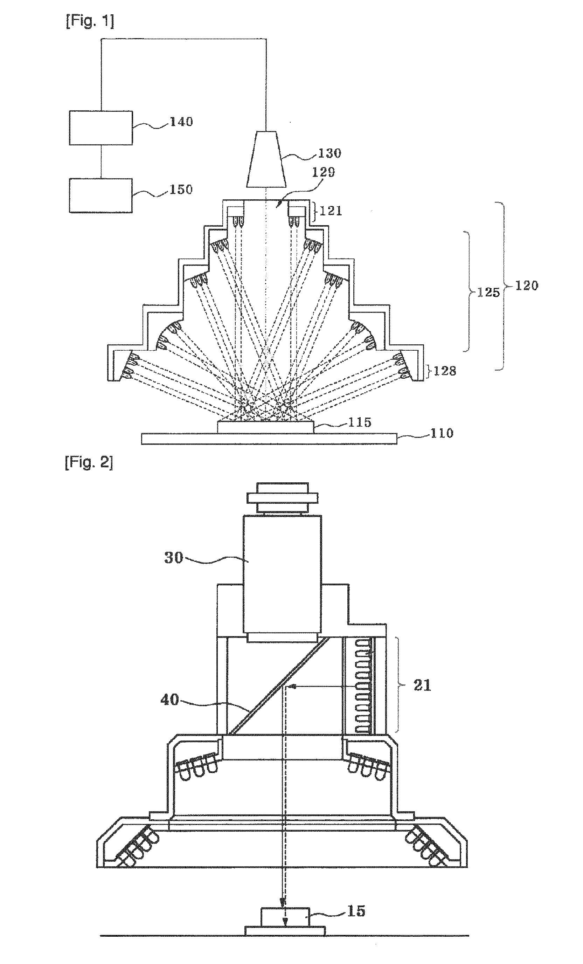

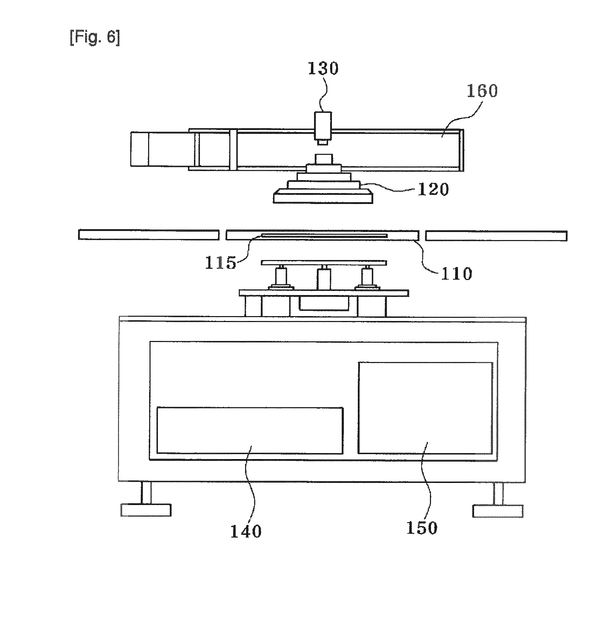

FIG. 1 illustrates a side sectional view of a contactless component-inspecting apparatus according to one aspect of the present invention. FIG. 6 illustrates a side sectional view of an entire contactless mounting inspection apparatus according to one embodiment of the present invention. Referring to FIG. 1 and FIG. 6, the contactless mounting inspection apparatus includes stage unit 110, a lighting unit 120, a camera 130, an image-processing unit 140, and a control unit 150.

The stage unit 110 serves to provide a space on which the inspection object 115 to be inspected is mounted. The stage unit 110 can include a location adjusting unit (not shown) and a fixing unit (not shown) for adjusting and fixing the location of the inspection object 115 therein.

The lighting unit 120 is located on an upper portion of the stage unit 110. The lighting unit 120 serves to provide the lighting on the inspection object 115 so as to secure the correct image information of the inspection object 115. A plurality of lamps is arranged on the outer side surface of a sight securing unit 129 which passes through the center thereof, so that the inspection object 115 can be illuminated from every direction.

The lighting unit includes a first white lighting portion 121, a color lighting portion 125, and a second white lighting portion 128.

The first white lighting portion 121 is located on the upper portion of the lighting unit 120 and irradiates the inspection object with white lights. It is preferred that the optical axis of the first white lighting portion 121 is parallel to that of the camera 130.

FIG. 2 illustrates a side sectional view of a lighting unit and a camera of the existing component-inspecting apparatus.

Referring to FIG. 2, the existing component-inspecting apparatus includes a lighting unit 21 having the optical axis perpendicular to that of a camera 30 and a half-reflection mirror 40, so that the light is irradiated on the inspection object 15 in a direction parallel to the optical axis of the camera 30.

On the contrary, since the optical axis of the first white lighting portion 121 according to the present invention disclosed in FIG. 1 is parallel to that of the camera 130, it does not need the separate half-reflection mirror 40. Accordingly, in the contactless component-inspecting apparatus according to the present invention, the manufacturing cost can be reduced. Also, it can prevent the part of the radiated by the lighting unit from being absorbed in the half-reflection mirror, so that the amount of light, which is radiated to the inspection object, can be increased.

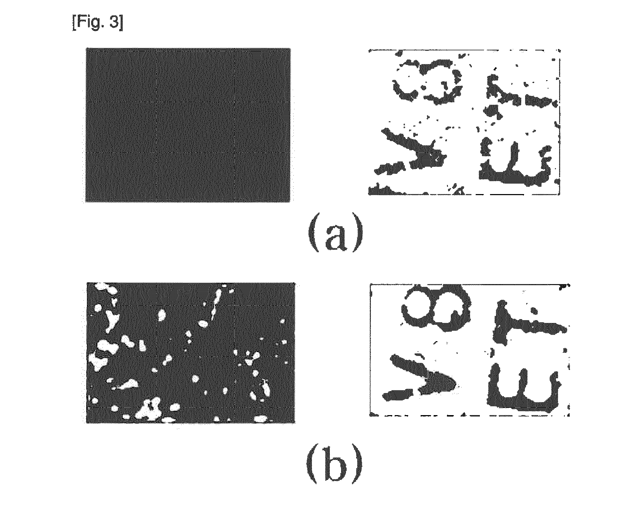

The first white lighting portion 121 is mainly useful in recognizing the character potion of the inspection object 115, especially the intagliated marking character portion. FIG. 3 is images obtained by photographing a character portion, which is marked on a body portion of an electric component mounted on the printed circuit board, by means of the image-inspecting apparatus. The photographs located in the left of (a) and (b) of FIG. 3 are original images and other photographs located in the right of (a) and (b) of FIG. 3 are binary coded images.

The photographs of FIG. 3 (a) and (b) are the original images and the binary coded images obtained when the white light is irradiated on the electric component, which is the inspection object, at an angle of 45 degrees and 0 degree (in parallel) about the optical axis of the camera 130 respectively. As shown in FIG. 3 (a) and (b), where the original image (FIG. 3 (a)) obtained by irradiating the light at an angle of 45 degrees about the optical axis of the camera 130 is compared with the original image (FIG. 3 (b)) obtained by irradiating the light in parallel with the optical axis of the camera 130, since the intensity of radiation of the light reflected from the surface of the electric component and income to on the camera 130 in FIG. 3 (a) is smaller than that of FIG. 3 (b), the image of FIG. 3 (a) is darker than that of FIG. 3 (b). Accordingly, it is not easy to identify the character portion of the inspection object 115 in the original image of FIG. 3 (a).

In case of the binary coded images, where the binary coded image (FIG. 3 (a)) obtained by irradiating at an angle of 45 degrees about the optical axis of the camera 130 is compared with the binary coded image (FIG. 3 (b)) obtained by irradiating in parallel with the optical axis of the camera 130, since the binary coded image of FIG. 3 (a) is larger than that of FIG. 3 (b)in terms of the noise, it is necessary to correct the binary coded image of FIG. 3 (a).

Again, referring to FIG. 1, the color lighting portion 125 can irradiate visual lights having different wavelength ranges on the inspection object 115. That is, the color lighting portion 125 can irradiate at least four types (preferably, at least five types) of visual lights having different wavelength ranges on the inspection object 115. The color lighting unit 125 may include a red lamp, a yellow lamp, a green lamp, a blue lamp, and a violet lamp.

The color lighting unit 125 irradiates the visible lights at different angles and different heights on the inspection object 115, so that the quality of the soldering part of the inspection object 115 can be accurately determined.

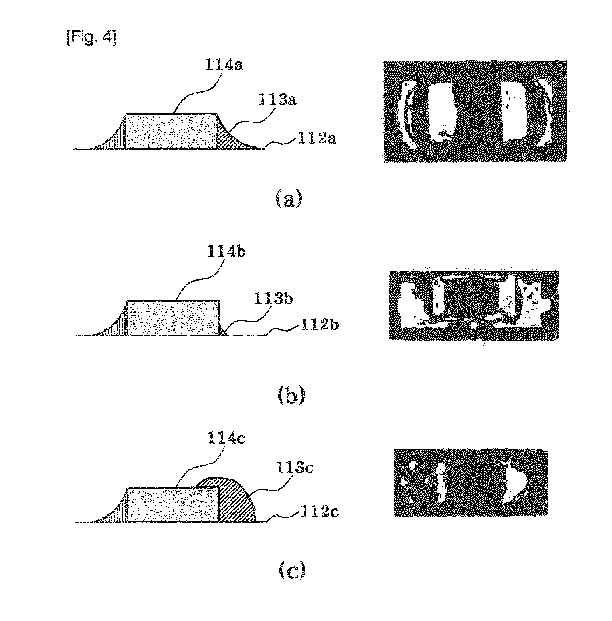

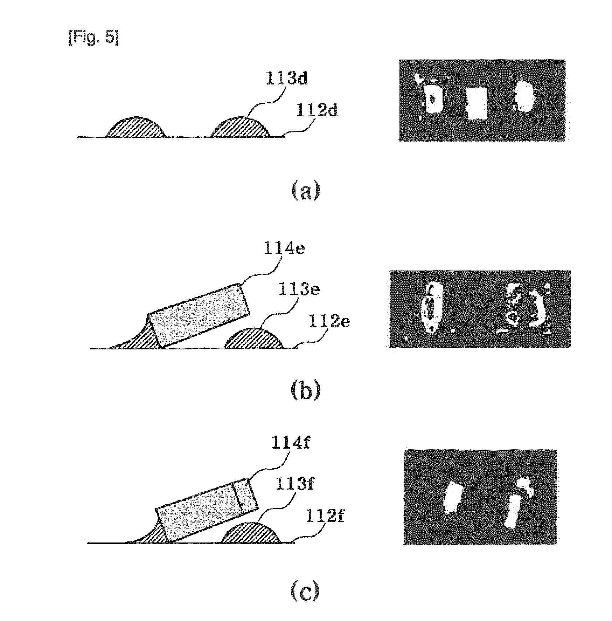

FIG. 4 and FIG. 5 are side views illustrating the shape of the soldering part for connecting the electric component as an inspection object with the printed circuit board and images obtained by photographing the inspection object through a camera.

FIG. 4 (a) is the image illustrating a good condition of the soldering part between the electric component and the printed circuit board. Hereinafter, the images of illustrating a bad condition of the soldering part between the electric component and the printed circuit board will be explained. FIG. 4 (b) is the image of illustrating any status in that the amount of the soldering part between the electric component and the printed circuit board is relatively small or the soldering working is not conducted. Generally, if the amount of the soldering part, which is soldered on the pad of the printed circuit board is 1/2 or less, it is faulty. FIG. 4 (c) is the image of illustrating any status in that the amount of the soldering part between the electric component and the printed circuit board is relatively exceeded. If the amount of the soldering part is relatively exceeded, since the parts, which should not be connected to each other, can be circuit-shorted, it is faulty.

FIG. 5 (a) is the image of illustrating any status in that the electric component is not mounted on the printed circuit board. That is, the electric component could not be mounted on the mounting position by means of a mounting equipment or the electric component could not be mounted owing to the movement of the printed circuit board. FIG. 5 (b) is the image of illustrating any status in that the electric component is not connected to the printed circuit board owing to the lifting of one side of the electric component. FIG. 5 (c) is the image of illustrating any status in that the electric component is not connected to the printed circuit board owing to the lifting and distortion of one side of the electric component.

The color lighting portion 125 includes at least four visual light lamps so as to irradiate the visual lights on the inspection object 115. Accordingly, the color distribution of the images of the soldering part can be subdivided, so that it can accurately understand the soldering shape thereof, thereby more accurately determining the quality of the soldering part of the inspection object 115.

Again, referring to FIG. 1, the second white lighting unit 128 is located on the lower portion of the color lighting unit 125. It is preferred that the second white lighting unit 128 irradiates the white lights at an angle of less than 45° about the plane of the color lighting unit 125. The second white lighting unit 128 servers to compensate the dark part generated when the inspection object 115 is irradiated through only the color lighting unit 125. Also, the recognition rate of the character portion of the inspection object can be enhanced. Moreover, where it is important to grasp the unique color of the inspection object 115 like the color band resistor, there is an advantage capable of perceiving the unique color of the inspection object 115.

The image-processing unit 140 serves to compare the image captured by the camera 130 with the image information previously inputted so as to determine whether the inspection object passes or fails the image inspection.

The control unit 150 is an element including a motion controller (not shown) for controlling the driving and the operation of the stage unit 110 and the camera 130. Also, it can control the entire driving of the contactless mounting inspection apparatus according to the present invention.

That is, the control unit 150, as shown in FIG. 6, allows the contactless mounting inspection apparatus to be transferred in every direction at the upper portion of the fixed inspection object 115 and transmits the photographing control signals to the camera 130 according to the pre-set photographing region of the inspection object 115.

Also, the control unit 150 serves to physically control the photographing position of the contactless mounting inspection apparatus, the process of the photographed images, and the lighting unit 120 according to the system control program and perform the inspection process and the data operation task.

Moreover, the control unit 150 serves to generally control the contactless mounting inspection apparatus. That is, it serves to control the output device for outputting the working contents and the inspection results to the monitor and the input device for inputting the establishment and various matters by means of the operator.

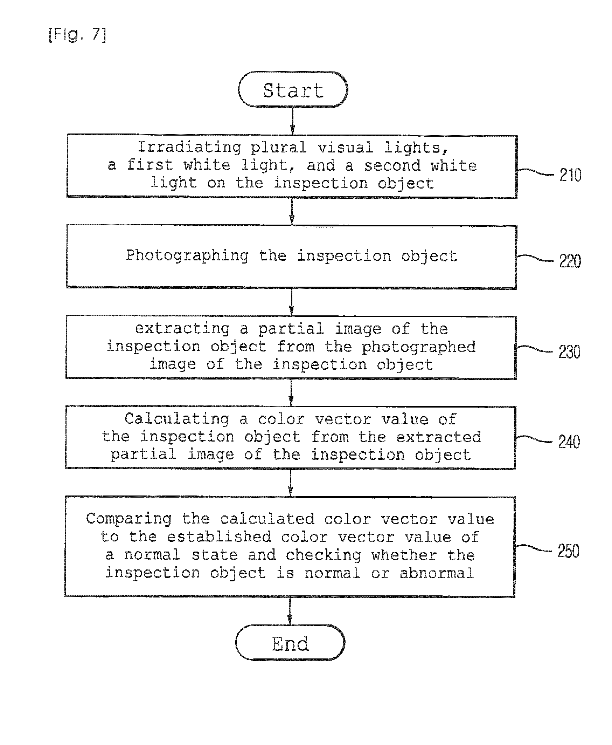

FIG. 7 is a flowchart illustrating a contactless component-inspecting method according to another aspect of the present invention.

In the step 210, the plural visible lights, and the first white light, and the second white light are irradiated on the inspection object. The plural visible lights have the wavelength ranges of at least four kinds, preferably, at least five kinds. The plural visible lights may include a red lamp, a yellow lamp, a green lamp, a blue lamp, and a violet lamp.

The first white light above the plural visible lights is irradiated on the inspection object. Also, it is advantageous to accurately recognize the character potion of the inspection object, especially the intagliated marking character portion.

The second white light is irradiated on the inspection object under the plural visible lights. At this time, the second white light can compensate the dark part generated when the inspection object is irradiated through only the plural visible lights. Also, the recognition rate of the character portion of the inspection object can be enhanced. Moreover, where it is important to grasp the unique color of the inspection object 115 like the color band resistor, there is an advantage capable of perceiving the unique color of the inspection object.

In the step 220, when the plural visible lights, the first white light, and the second white light are reflected from the inspection object and then, are income to the camera, the camera takes a picture of the inspection object.

In the step 230, the partial image of the inspection object is extracted from the image of the inspection object. The process of extracting the partial image of the inspection object can include at least any one among a process of extracting the main body image of the inspection object and a process of extracting the image of the soldering part of the inspection object. The main body image of the inspection object may include the character portion marked in the inspection object and the information including the color of the main body of the inspection object etc.

In the step 240, the rate, shape, and characteristic etc. of the color region of the inspection object are calculated from the partial image of the inspection object, so that the color vector values are calculated. The color vector value may include any information such as the character portion of the main body of the inspection object 115, the color thereof, and the gradient and the surface figure etc. of the soldering part.

In the step 250, the calculated color vector value is compared to the established color vector value of the normal state, so that it can check whether the inspection object is normal or abnormal.

Although a preferred embodiment of the present invention has been described for illustrative purposes, those skilled in the art will appreciate that various modifications, additions and substitutions are possible, without departing from the scope and spirit of the invention as disclosed in the accompanying claims.

## Claims

1. A contactless component-inspecting apparatus for comparing a photographed image of an inspection object with a previously inputted image, after the inspection object assembled or mounted during a component assembly process is photographed through a camera, and determining whether the inspection object passes or fails an image inspection, comprising:
a stage unit for mounting the inspection object thereon and fixing or transferring the inspection object to an inspection location thereof;
a lighting unit having a color lighting portion for irradiating at least four types of visual lights having different wavelength ranges on the inspection object, a first white lighting portion for irradiating a white light on the inspection object located on an upper portion of the color lighting portion, and a second white lighting portion for irradiating a white light on the inspection object located on a lower portion of the color lighting portion;
a camera for photographing the inspection object located above the lighting unit;
an image-processing unit for reading the image photographed by the camera and determining whether the inspection object passes or fails the image inspection; and
a control unit having a motion controller for controlling the stage unit and the camera.

2. A contactless component-inspecting apparatus as claimed in claim 1, wherein the optical axis of the first white lighting portion is parallel to that of the camera.

3. A contactless component-inspecting apparatus as claimed in claim 1, wherein the white light irradiated by the second white lighting unit is irradiated at an angle of less than 45° about a plane of the inspection object.

4. A contactless component-inspecting apparatus as claimed in claim 1, wherein the color lighting unit comprises a red lamp, a yellow lamp, a green lamp, a blue lamp, and a violet lamp.

5. A contactless component-inspecting apparatus as claimed in claim 1, wherein the color lighting unit irradiates the visible lights at different angles and different heights on the inspection object.

6. A contactless component-inspecting method for comparing a photographed image of an inspection object with a previously inputted image, after the inspection object assembled or mounted during a component assembly process is photographed through a camera, and determining whether the inspection object passes or fails an image inspection, comprising steps of:
irradiating at least four types of visual lights having different wavelength ranges, a first white light located on an upper portion of the visual lights, and a second white light located on a lower portion of the visual lights on the inspection object;
photographing the inspection object through the camera;
extracting a partial image of the inspection object from the photographed image of the inspection object;
calculating a color vector value of the inspection object from the extracted partial image of the inspection object; and
comparing the calculated color vector value to the established color vector value of a normal state and checking whether the inspection object is normal or abnormal.

7. A contactless component-inspecting method as claimed in claim 6, wherein the inspection object is an electric component mounted on the printed circuit board.

8. A contactless component-inspecting method as claimed in claim 6, wherein the first white light is irradiated on the inspection object in parallel with an optical axis of the camera.

9. A contactless component-inspecting method as claimed in claim 6, wherein the process of extracting the partial image of the inspection object comprises at least any one among a process of extracting the main body image of the inspection object and a process of extracting the image of the soldering part of the inspection object.

10. A contactless component-inspecting method as claimed in claim 6, wherein the plural visible light comprises a red wavelength light, a yellow wavelength light, a green wavelength light, a blue wavelength light, and a violet wavelength light.
